# FASCICULE DE BREVET EUROPEEN

(11) **EP 3 333 992 B1**
(45) Date de publication et mention de la délivrance du brevet: **17.02.2021**
(21) Numéro de dépôt: 17193774.1
(22) Date de dépôt: 28.09.2017
(51) Int. Cl.: H02B 1/052, H02B 1/56

(54) **DISPOSITIF DE VENTILATION DE L'AIR A L'INTERIEUR D'UNE ENVELOPPE DESTINEE A LOGER DES APPAREILS ELECTRIQUES MODULAIRES, ET ENVELOPPE COMPORTANT UN TEL DISPOSITIF**
BELÜFTUNGSGEBLÄSE IM INNERN EINER UMHÜLLUNG ZUR AUFNAHME VON MODULAREN ELEKTRISCHEN GERÄTEN, UND UMHÜLLUNG, DIE EINE SOLCHE VORRICHTUNG UMFASST
AIR VENTILATION DEVICE INSIDE AN ENCLOSURE INTENDED TO HOUSE MODULAR ELECTRICAL UNITS, AND ENCLOSURE COMPRISING SUCH A DEVICE

(30) Priorité: 08.12.2016 FR 1662153
(43) Date de publication de la demande: 13.06.2018
(73) Titulaire: Schneider Electric Industries SAS, 92500 Rueil-Malmaison (FR)
(72) Inventeur: LINARES, Louis, 38050 GRENOBLE (FR)
(74) Mandataire: Colette, Marie-Françoise

(56) Documents cités:
- DE-A1-102004 008 513
- DE-A1-102014 104 857

## Description

### DOMAINE TECHNIQUE

La présente invention concerne un dispositif de ventilation de l'air à l'intérieur d'une enveloppe destinée à loger des appareils électriques modulaires montés sur un rail de montage, ainsi qu'une enveloppe comportant un tel dispositif.

### ETAT DE LA TECHNIQUE ANTERIEURE

Le problème de la stagnation de l'air chaud dans les enveloppes d'appareillages électriques peut conduire à ne pas respecter les standards normatifs, à accélérer le vieillissement des appareils, à devoir déclasser les appareils.

Afin de pallier à cet inconvénient, il existe la solution consistant à installer des ventilateurs dans les enveloppes, ces ventilateurs étant généralement solidaires des enveloppes. Cette solution est compliquée et peu utilisée, principalement sur les gros modèles.

On connaît le brevet EP1053581 décrivant une armoire électrique comportant un dispositif de ventilation, ce dispositif comportant un certain nombre de ventilateurs fixés sur la face interne de l'une des parois de l'enveloppe. Il est nécessaire de réaliser une découpe non standard pour installer de tels ventilateurs. D'autre part, il n'est pas possible de placer ces ventilateurs à côté d'une source de chaleur et sur un rail DIN.

On connaît le document DE 10 2004 008513 décrivant un dispositif comportant les caractéristiques de préambule de la revendication 1.

La présente invention résout ces problèmes et propose un dispositif de ventilation de conception simple pouvant être placée au côté d'une source de chaleur sur un rail DIN, et ne nécessitant pas de modifier la paroi de l'enveloppe pour son installation.

### EXPOSE DE L'INVENTION

A cet effet, la présente invention a pour objet un dispositif de ventilation de l'air à l'intérieur d'une enveloppe destinée à loger des appareils électriques modulaires montés sur un rail de montage, selon la revendication 1.

Selon une caractéristique, le moyen d'obturation défini dans la revendication 1 est un clapet articulé sur une partie intérieure du boîtier du ventilateur.

Selon une autre caractéristique, ce dispositif de ventilation comporte au moins un capteur thermique, et des moyens de déclenchement automatiques du dispositif de ventilation précité commandés par ledit capteur thermique.

Selon une autre caractéristique, ce dispositif comporte au moins un capteur d'humidité, et des moyens de chauffage commandés par ledit capteur d'humidité.

Selon une autre caractéristique, les moyens de chauffage précités comportent une résistance chauffante.

La présente invention a encore pour objet une enveloppe destinée à loger des appareils électriques modulaires, ces appareils électriques modulaires étant montés sur un rail de montage, cette enveloppe étant caractérisée en ce qu'elle comporte un dispositif de ventilation comportant les caractéristiques précédemment mentionnées prises seules ou en combinaison.

Selon une caractéristique particulière, le dispositif de ventilation précité est accolé à l'une des faces d'un appareil modulaire appartenant à une rangée d'appareils montés sur un même rail de montage.

Selon une autre caractéristique, une paroi de ladite enveloppe comportant, en regard de l'un ou de chaque rail de montage destiné à recevoir une rangée d'appareils, une ouverture allongée destinée à permettre le passage d'une partie formant nez des appareils, cette partie comportant la manette de manœuvre manuelle des appareils, cette enveloppe est caractérisée en ce que le dispositif de ventilation précité présente sensiblement la même forme extérieure qu'un appareil électrique modulaire, et comporte également une partie formant nez apte à passer à travers l'ouverture précitée de l'enveloppe de manière à permettre l'évacuation de l'air chaud à travers cette ouverture de l'enveloppe par l'intermédiaire d'une ouverture de sortie du ventilateur communiquant avec l'ouverture précitée de l'enveloppe.

Selon une autre caractéristique, le ou chaque ventilateur comporte un moyen d'obturation ou de libération de l'ouverture de sortie précitée du ventilateur en fonction du mode d'utilisation choisi pour ce dispositif de ventilation.

Selon une autre caractéristique, le dispositif de ventilation comporte en outre un élément modulaire formant grille apte à être monté sur un rail de montage, et comportant également une partie formant nez apte à être montée à travers l'une des ouvertures précitées de l'enveloppe de manière que l'air pénètre par la grille précitée et soit évacué par le dispositif de ventilation situé au voisinage d'une zone chaude de l'enveloppe.

Selon une autre caractéristique, le rail de montage est un rail DIN.

Mais d'autres avantages et caractéristiques de l'invention apparaîtront mieux dans la description détaillée qui suit et se réfère aux dessins annexés donnés uniquement à titre d'exemple et dans les quels :
- La figure 1 est une vue en perspective d'un dispositif de ventilation selon une réalisation particulière de l'invention,
- La figure 2 est une vue en perspective illustrant une autre réalisation de ce dispositif de ventilation sans ouverture de sortie vers l'extérieur, selon deux orientations différentes,
- La figure 3 illustre dans une vue en perspective, la mise en place dans une enveloppe d'un dispositif de ventilation en deux parties, selon une autre réalisation de l'invention,
- La figure 4 est une vue partiellement en perspective et partiellement en coupe, illustrant respectivement un ventilateur et l'interaction entre la porte de l'enveloppe et les appareils,
- La figure 5 est une vue en perspective illustrant le cheminement de l'air selon cette réalisation de l'invention illustrée sur les figures 3 et 4,
- Les figures 6,7 et 8 illustrent respectivement dans une vue en perspective, une vue en perspective montrant la partie intérieure de l'appareil et une vue en coupe, une utilisation particulière du dispositif de ventilation pour évacuer l'air chaud à l'extérieur de l'enveloppe, et
- Les figures 9,10 et 11 sont des vues similaires aux figures précédentes, mais montrant une autre utilisation particulière du dispositif de ventilation pour réaliser un brassage de l'air.

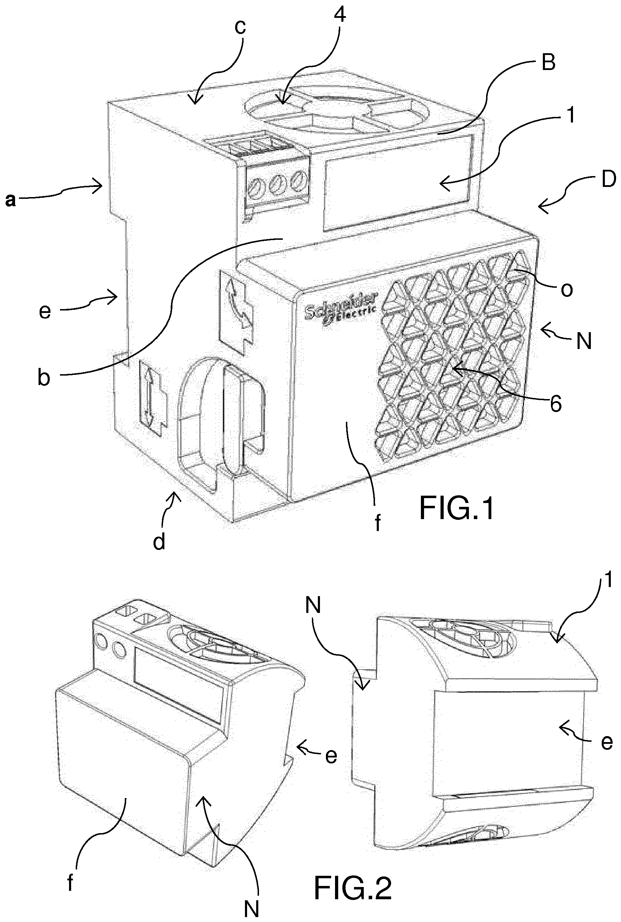

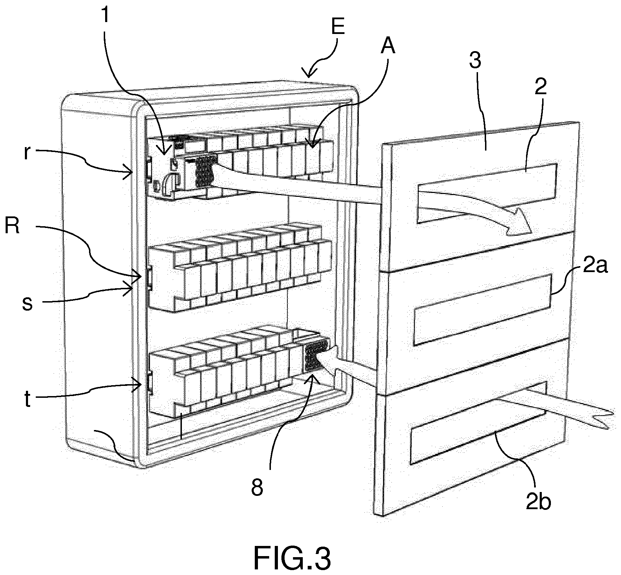

Sur les figures 1 et 2, on voit un dispositif de ventilation D comportant un ventilateur 1 destiné à être mis en œuvre dans une enveloppe E ou armoire électrique selon l'invention, ladite enveloppe logeant des appareils électriques de protection modulaires A, tel qu'illustré sur la figure 3.

A l'intérieur de cette armoire et de manière connue en soi, ces appareils sont montés sur des rails de montage R de manière alignée les uns par rapport aux autres et accolés par l'une de leurs faces latérales. A cet effet, les appareils comportent sur leur face arrière a, des moyens de fixation au rail R, ces moyens de fixation comprenant un évidement e formé dans cette face arrière coopérant avec une forme particulière du rail.

Conformément à l'invention, ce ventilateur 1 se présente sous la forme d'un module présentant une forme extérieure sensiblement similaire à la forme extérieure des autres appareils, ce module étant apte à être fixé sur le rail de montage de la même manière que les autres appareils. Ainsi, ce ventilateur est logé dans un boîtier B de forme sensiblement parallélépipédique comportant sur l'une a de ses faces, dite face arrière, des moyens de fixation au rail de montage, et sur sa face avant b, une partie formant nez N.

Cette partie formant nez est destinée à être introduite, comme ceci est le cas pour les autres appareils modulaires de l'enveloppe, dans une ouverture 2 de forme allongée prévue à cet effet dans la paroi 3 formant porte de l'enveloppe E. On voit en effet, que la porte de l'enveloppe comporte trois ouvertures allongées 2,2a,2b s'étendant en regard respectivement des trois rangées r,s,t d'appareils modulaires.

Ce ventilateur comporte sur ses deux faces opposées respectivement supérieure et inférieure c,d, un orifice 4,5, cet orifice étant destiné à permettre l'introduction de l'air dans l'appareil ou l'échappement de l'air vers l'extérieur de l'appareil.

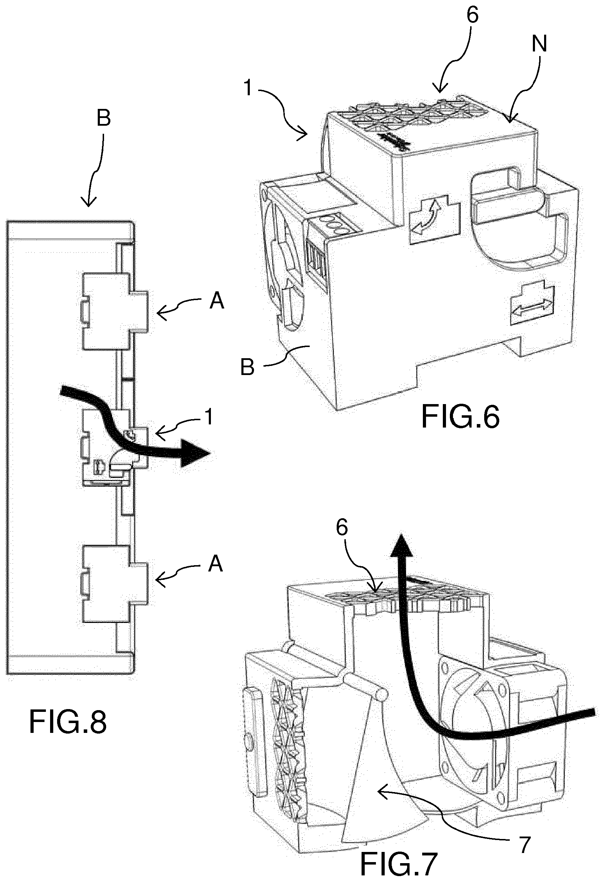

Ce ventilateur comporte également sur la face extérieure f du nez précité N, une ouverture de sortie 6 destinée à l'échappement de l'air chaud lorsque le dispositif de ventilation est utilisé pour véhiculer l'air chaud vers l'extérieur, cette ouverture pouvant être constituée par une pluralité d'orifices o. Selon une réalisation particulière de l'invention illustrée plus particulièrement sur les figures 6 à 11, cette ouverture de sortie 6 peut être obturée par un clapet 7 monté articulé par rapport au boîtier B de l'appareil de manière à pouvoir être amené par un utilisateur soit dans une première position dans laquelle cet obturateur ou clapet 7 ferme l' ouverture précitée 6 et empêche donc le passage de l'air à travers cette ouverture, soit une seconde position dans laquelle l'ouverture précitée 6 est libérée de manière à permettre l'échappement de l'air. Ainsi, la première position du clapet permet l'utilisation du dispositif de ventilation pour réaliser un brassage de l'air à l'intérieur de l'enveloppe, tandis que la seconde position du clapet permet au dispositif de ventilation d'être utilisé pour réaliser l'échappement de l'air chaud vers l'extérieur de l'enveloppe.

Avantageusement, ce dispositif de ventilation D selon l'invention comporte des capteurs thermiques pour détecter un échauffement à l'intérieur de l'enveloppe, et des moyens de déclenchement automatique du ventilateur suite à la survenue de cet échauffement.

Avantageusement également, et plus particulièrement lorsque ce ventilateur est utilisé uniquement pour le brassage de l'air à l'intérieur de l'enveloppe, ce ventilateur comporte des capteurs d'humidité, par exemple une résistance chauffante, apte à mesurer le taux d'humidité à l'intérieur de l'enveloppe, et des moyens de chauffage aptes à être commandés par les capteurs d'humidité, de manière à maintenir l'intérieur de l'enveloppe à la température souhaitée.

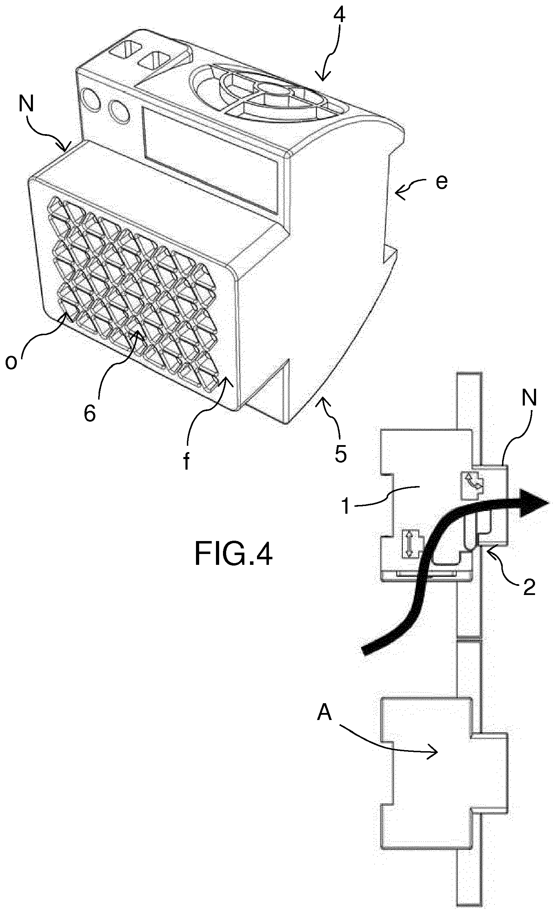

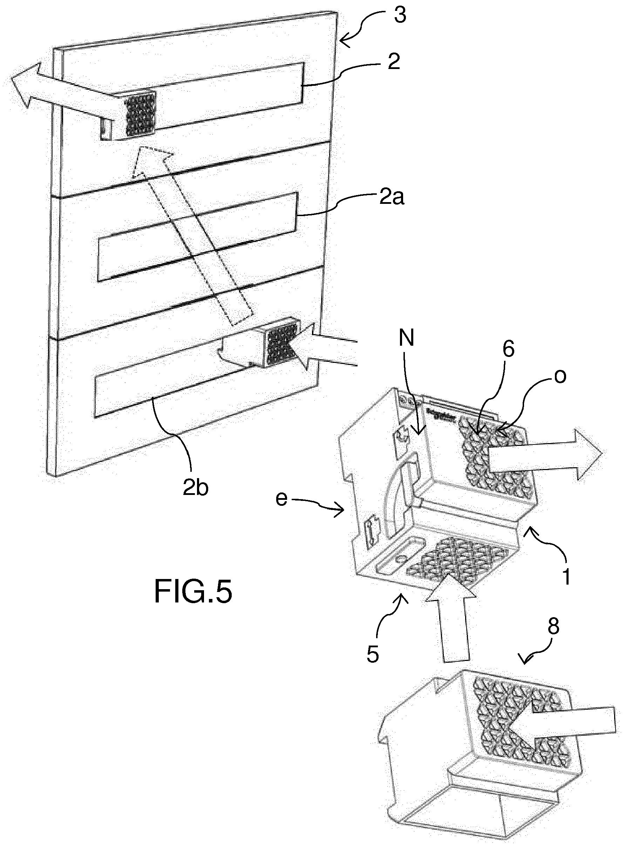

Selon la réalisation illustrée sur les figures 3 à 5, ce dispositif de ventilation D comporte un ventilateur 1 ainsi qu'une grille modulaire 8, ce ventilateur 1 étant placé à l'extrémité gauche de la rangée supérieure r des appareils modulaires, tandis que cette grille 8 est située à l'extrémité droite de la rangée inférieure t d'appareils modulaires.

Ainsi, tel qu'illustré sur les figures 3 à 5, l'air ambiant pénètre dans l'enveloppe E par la grille modulaire classique 8 et est évacué par le ventilateur 1 situé près des appareils constituant des sources de chaleur.

Tel qu'illustré sur les figures 6 à 8, le dispositif de ventilation D selon l'invention peut être utilisé pour évacuer l'air chaud à l'extérieur de l'enveloppe E par la partie formant nez N du ventilateur 1. Dans ce cas, le clapet 7 est en position ouverte.

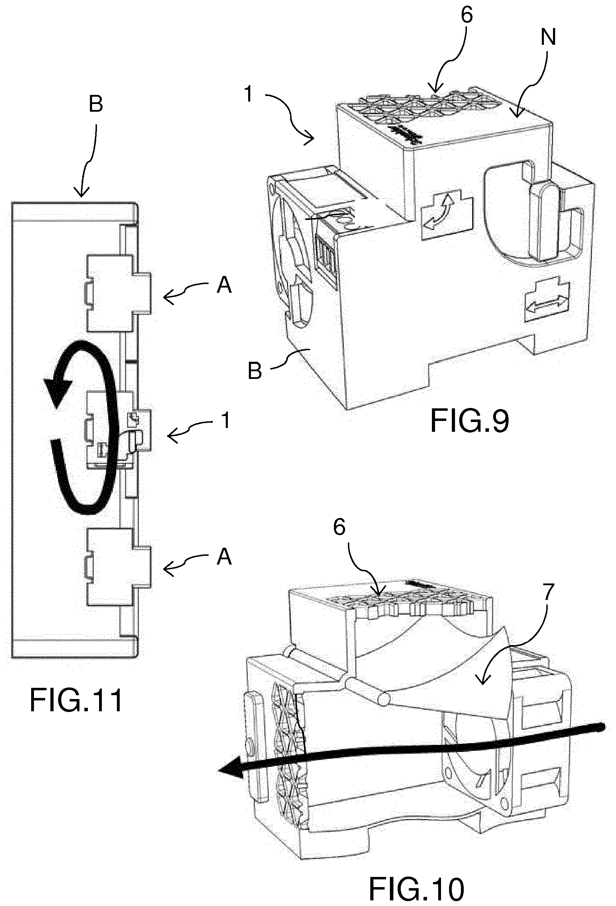

Tel qu'illustré sur les figures 9 à 11, le dispositif D selon l'invention est utilisé pour réaliser un brassage de l'air à l'intérieur de l'enveloppe E. Dans ce cas, le clapet 7 est en position fermée d'obturation de l'ouverture de sortie 6.

Ainsi, ce ventilateur selon l'invention se positionne comme n'importe quel appareil modulaire dans l'enveloppe et peut s'intégrer dans toutes les enveloppes. Il se positionne au plus près des appareils qui chauffent et se câble facilement.

Il n'est plus nécessaire de découper l'enveloppe, car l'on utilise la fenêtre modulaire existante afin d'évacuer l'air chaud à l'extérieur de l'enveloppe.

On a donc réalisé selon l'invention, un dispositif de ventilation apte à pouvoir être installé dans tout type d'enveloppe, tiroir compris, afin de créer une circulation d'air interne (dit brassage) ou d'évacuer l'air chaud de l'enveloppe. Pouvant être installé sur un rail modulaire, ce ventilateur est totalement indépendant de l'enveloppe. Son raccordement ainsi que celui des autres appareils modulaires est ainsi simplifié.

Bien entendu, l'invention n'est pas limitée aux modes de réalisation décrits et illustrés qui n'ont été donnés qu'à titre d'exemple.

Au contraire, l'invention comprend tous les équivalents techniques des moyens décrits ainsi que leurs combinaisons si celles-ci sont réalisées suivant les revendications annexées.

## Revendications

1. Dispositif de ventilation de l'air à l'intérieur d'une enveloppe destinée à loger des appareils électriques modulaires montés sur un rail de montage, ledit dispositif comportant au moins un ventilateur (1) se présentant sous la forme d'un module configuré pour être fixé sur ledit rail de montage (R) aux côtés des autres appareils (A), le ou chaque ventilateur (1) comportant des moyens pour créer un brassage d'air à l'intérieur de l'enveloppe E, et des moyens pour évacuer l'air chaud présent à l'intérieur de l'enveloppe E vers l'extérieur de l'enveloppe à travers une ouverture de sortie (6) prévue dans le boîtier B du ventilateur (1), ladite ouverture de sortie (6) configurée pour communiquer avec une ouverture (2) prévue dans une paroi (3) de l'enveloppe E, **caractérisé en ce que** le ou chaque ventilateur précité (1) comporte un moyen (7) d'obturation ou de libération de l'ouverture de sortie précitée (6) du ventilateur (1) en fonction du mode d'utilisation choisi pour ce dispositif de ventilation D, ces modes comprenant pour l'un, l'obturation de l'ouverture précitée permettant de réaliser un brassage de l'air à l'intérieur de l'enveloppe, et pour l'autre, la libération de l'ouverture permettant l'échappement de l'air chaud vers l'extérieur de l'enveloppe.

2. Dispositif de ventilation selon la revendication 1, **caractérisé en ce que** ce moyen est un clapet articulé sur une partie intérieure du boîtier (B) du ventilateur (1).

3. Dispositif de ventilation selon l'une quelconque des revendications précédentes, **caractérisé en ce qu'**il comporte au moins un capteur thermique, et des moyens de déclenchement automatiques du dispositif de ventilation précité commandés par ledit capteur thermique.

4. Dispositif de ventilation selon l'une quelconque des revendications précédentes, **caractérisé en ce qu'**il comporte au moins un capteur d'humidité, et des moyens de chauffage commandés par ledit capteur d'humidité.

5. Dispositif de ventilation selon la revendication 4, **caractérisé en ce que** les moyens de chauffage précités comportent une résistance chauffante.

6. Enveloppe destinée à loger des appareils électriques modulaires, ces appareils électriques modulaires A étant montés sur un rail de montage (R), **caractérisée en ce qu'**elle comporte un dispositif de ventilation (D) selon l'une quelconque des revendications 1 à 5.

7. Enveloppe selon la revendication 6, **caractérisée en ce que** le dispositif de ventilation précité (D) est accolé à l'une des faces d'un appareil modulaire A appartenant à une rangée d'appareils (r,s,t) montés sur un même rail de montage (R).

8. Enveloppe selon la revendication 6 ou 7, **caractérisée en ce qu'**une paroi de ladite enveloppe comportant, en regard de l'un ou de chaque rail de montage destiné à recevoir une rangée d'appareils, une ouverture allongée (2,2a,2b) destinée à permettre le passage d'une partie formant nez des appareils, cette partie comportant une manette de manœuvre manuelle des appareils, le dispositif de ventilation précité (D) présentant sensiblement la même forme extérieure qu'un appareil électrique modulaire A, et comporte également une partie formant nez N apte à passer à travers l'ouverture précitée (2,2a,2b) de l'enveloppe E de manière à permettre l'évacuation de l'air chaud à travers cette ouverture de l'enveloppe par l'intermédiaire d'une ouverture de sortie (6) du ventilateur (1) communiquant avec l'ouverture précitée (2,2a,2b) de l'enveloppe E.

9. selon l'une quelconque des revendications 6 à 8, **caractérisée en ce que** le dispositif de ventilation (D) comporte en outre un élément modulaire formant grille (8) apte à être monté sur un rail de montage (R), et comportant également une partie formant nez (N) apte à être montée à travers l'une des ouvertures précitées (2,2a,2b) de l'enveloppe E de manière que l'air pénètre par la grille précitée (8) et soit évacué par le dispositif de ventilation (D) situé au voisinage d'une zone chaude de l'enveloppe E.

10. selon l'une quelconque des revendications 6 à 10, **caractérisée en ce que** le rail de montage (R) est un rail DIN.

## Patentansprüche

1. Belüftungsvorrichtung zur Belüftung im Inneren einer Umhüllung, die dazu bestimmt ist, modulare elektrische Geräte aufzunehmen, die auf einer Montageschiene angebracht sind, wobei die Vorrichtung mindestens einen die Form eines Moduls aufweisenden Lüfter (1) umfasst, der dafür ausgelegt ist, auf der Montageschiene (R) neben den anderen Geräten (A) befestigt zu werden, wobei der oder jeder Lüfter (1) Mittel zum Erzeugen einer Luftumwälzung im Inneren der Umhüllung E und Mittel zum Abführen der im Inneren der Umhüllung E vorhandenen heißen Luft durch eine im Gehäuse B des Lüfters (1) vorgesehene Austrittsöffnung (6) aus der Umhüllung hinaus umfasst, wobei die Austrittsöffnung (6) dafür ausgebildet ist, mit einer in einer Wand (3) der Umhüllung E vorgesehenen Öffnung (2) in Verbindung zu stehen, **dadurch gekennzeichnet, dass** der oder jeder genannte Lüfter (1) ein Mittel (7) zum Verschließen oder zur Freigabe der genannten Austrittsöffnung (6) des Lüfters (1) in Abhängigkeit von der für diese Belüftungsvorrichtung D gewählten Verwendungsweise umfasst, wobei diese Verwendungsweisen für die eine das Verschließen der genannten Öffnung, welches ermöglicht, eine Umwälzung der Luft im Inneren der Umhüllung durchzuführen, und für die andere die Freigabe der Öffnung, die das Entweichen der heißen Luft aus der Umhüllung hinaus ermöglicht, umfassen.

2. Belüftungsvorrichtung nach Anspruch 1, **dadurch gekennzeichnet, dass** dieses Mittel eine Klappe ist, die an einem inneren Teil des Gehäuses (B) des Lüfters (1) angelenkt ist.

3. Belüftungsvorrichtung nach einem der vorhergehenden Ansprüche, **dadurch gekennzeichnet, dass** sie mindestens einen Temperatursensor und Mittel zur automatischen Auslösung der genannten Belüftungsvorrichtung, die von dem Temperatursensor gesteuert werden, umfasst.

4. Belüftungsvorrichtung nach einem der vorhergehenden Ansprüche, **dadurch gekennzeichnet, dass** sie mindestens einen Feuchtigkeitssensor und Heizmittel, die von dem Feuchtigkeitssensor gesteuert werden, umfasst.

5. Belüftungsvorrichtung nach Anspruch 4, **dadurch gekennzeichnet, dass** die genannten Heizmittel einen Heizwiderstand umfassen.

6. Umhüllung, welche dazu bestimmt ist, modulare elektrische Geräte aufzunehmen, wobei diese modularen elektrischen Geräte A auf einer Montageschiene (R) angebracht sind, **dadurch gekennzeichnet, dass** sie eine Belüftungsvorrichtung (D) nach einem der Ansprüche 1 bis 5 umfasst.

7. Umhüllung nach Anspruch 6, **dadurch gekennzeichnet, dass** die genannte Belüftungsvorrichtung (D) an eine der Seiten eines modularen Gerätes A angefügt ist, das zu einer Reihe von Geräten (r, s, t) gehört, die auf ein und derselben Montageschiene (R) angebracht sind.

8. Umhüllung nach Anspruch 6 oder 7, **dadurch gekennzeichnet, dass** eine Wand der Umhüllung gegenüber der einen oder jeder Montageschiene, die dazu bestimmt ist, eine Reihe von Geräten aufzunehmen, eine lang gestreckte Öffnung (2, 2a, 2b) umfasst, die dazu bestimmt ist, den Durchgang eines eine Nase bildenden Teils der Geräte zu ermöglichen, wobei dieser Teil ein Mittel zur manuellen Betätigung der Geräte umfasst, wobei die genannte Belüftungsvorrichtung (D) im Wesentlichen dieselbe äußere Form wie ein modulares elektrisches Gerät A aufweist und ebenfalls einen eine Nase N bildenden Teil umfasst, der geeignet ist, sich durch die genannte Öffnung (2, 2a, 2b) der Umhüllung E zu erstrecken, um so die Abführung der heißen Luft durch diese Öffnung der Umhüllung hindurch über eine Austrittsöffnung (6) des Lüfters (1), die mit der genannten Öffnung (2, 2a, 2b) der Umhüllung E in Verbindung steht, zu ermöglichen.

9. Umhüllung nach einem der Ansprüche 6 bis 8, **dadurch gekennzeichnet, dass** die Belüftungsvorrichtung (D) außerdem ein modulares Element umfasst, das ein Gitter (8) bildet, das auf einer Montageschiene (R) montierbar ist und ebenfalls einen eine Nase (N) bildenden Teil umfasst, der geeignet ist, durch eine der genannten Öffnungen (2, 2a, 2b) der Umhüllung E hindurch angebracht zu werden, derart, dass die Luft durch das genannte Gitter (8) dringt und von der Belüftungsvorrichtung (D), die sich in der Nähe eines heißen Bereichs der Umhüllung E befindet, abgeführt wird.

10. Umhüllung nach einem der Ansprüche 6 bis 10, **dadurch gekennzeichnet, dass** die Montageschiene (R) eine DIN-Schiene ist.

## Claims

1. Air ventilation device inside an enclosure intended to house modular electrical units mounted on a mounting rail, said device comprising at least one fan (1) in the form of a module configured to be fixed onto said mounting rail (R) alongside the other units (A), the or each fan (1) comprising means for creating a stirring of air inside the enclosure E, and means for discharging the hot air present inside the enclosure E to the outside of the enclosure through an outlet opening (6) provided in the casing B of the fan (1), said outlet opening (6) configured to communicate with an opening (2) provided in a wall (3) of the enclosure E, **characterized in that** the or each abovementioned fan (1) comprises a means (7) for shutting or freeing the abovementioned outlet opening (6) of the fan (1) according to the mode of use chosen for this ventilation device D, these modes comprising, for the one, the shutting of the abovementioned opening for carrying out a stirring of the air inside the enclosure, and, for the other, the freeing of the opening allowing the hot air to escape to the outside of the enclosure.

2. Ventilation device according to Claim 1, **characterized in that** this means is a shutter articulated on an internal part of the casing B of the fan (1).

3. Ventilation device according to either one of the preceding claims, **characterized in that** it comprises at least one thermal sensor, and means for automatically triggering the abovementioned ventilation device controlled by said thermal sensor.

4. Ventilation device according to any one of the preceding claims, **characterized in that** it comprises at least one humidity sensor, and heating means controlled by said humidity sensor.

5. Ventilation device according to Claim 4, **characterized in that** the abovementioned heating means comprise a heating resistor.

6. Enclosure intended to house modular electrical units, these modular electrical units A being mounted on a mounting rail (R), **characterized in that** it comprises a ventilation device (D) according to any one of Claims 1 to 5.

7. Enclosure according to Claim 6, **characterized in that** the abovementioned ventilation device (D) is attached to one of the faces of a modular unit A belonging to a row of units (r, s, t) mounted on one and the same mounting rail (R).

8. Enclosure according to Claim 6 or 7, **characterized in that** a wall of said enclosure comprises, facing one or each mounting rail intended to receive a row of units, an elongate opening (2, 2a, 2b) intended to allow the passage of a nose-forming part of the units, this part comprising a manual operating lever of the units, the abovementioned ventilation device (D) having substantially the same outer form as a modular electrical unit A, and also comprises a nose-forming part N that can pass through the abovementioned opening (2, 2a, 2b) of the enclosure E so as to allow the discharging of the hot air through this opening of the enclosure via an outlet opening (6) of the fan (1) communicating with the abovementioned opening (2, 2a, 2b) of the enclosure E.

9. Enclosure according to any one of Claims 6 to 8, **characterized in that** the ventilation device (D) further comprises a grille-forming modular element (8) that can be mounted on a mounting rail (R), and also comprising a nose-forming part (N) that can be mounted through one of the abovementioned openings (2, 2a, 2b) of the enclosure E so that the air penetrates through the abovementioned grille (8) and is discharged by the ventilation device (D) situated in the vicinity of a hot zone of the enclosure E.

10. Enclosure according to any one of Claim 6 to 10, **characterized in that** the mounting rail (R) is a DIN rail.
